# EUROPÄISCHE PATENTANMELDUNG

(11) **EP 0 641 076 A1**
(43) Veröffentlichungstag der Anmeldung: **01.03.1995**
(21) Anmeldenummer: 94112709.4
(22) Anmeldetag: 13.08.1994
(51) Int. Cl.: H03J 1/00

(54) **Verfahren zur Unterstützung eines Rundfunkhörers beim Einstellen einer Sendung**

(30) Priorität: 31.08.1993 DE 4329206
(71) Anmelder: Alcatel SEL Aktiengesellschaft, D-70435 Stuttgart (DE)
(72) Erfinder: Noller, Manfred, D-70567 Stuttgart (DE)
(74) Vertreter: Brose, Gerhard

(57) **Zusammenfassung**

Die vorliegende Erfindung gibt Verfahren zur Unterstützung eines Rundfunkhörers beim Einstellen einer Sendung an einem Rundfunkempfangsgerät an, bei denen das Rundfunkempfangsgerät selbständig eine Sendung einstellt aufgrund eines Vergleichs zwischen Daten, die aus Einstellhandlungen des Rundfunkhörers gewonnen wurden und Daten, die vom Rundfunkemfangsgerät als Begleitdaten von Rundfunksendungen empfangen wurden.

## Beschreibung

Die Erfindung betrifft ein Verfahren zur Unterstützung eines Rundfunkhörers nach dem Oberbegriff des Hauptanspruchs.

Schon sehr früh in der Rundfunktechnik wurden dem Rundfunkhörer Möglichkeiten geboten, die ihn beim Einstellen einer Sendung unterstützen können. Beispiele sind das "Magische Auge", das die manuelle Frequenzfeineinstellung erleichtert, die Auswertung des Pilottons bei Stereosendungen zur automatischen Umschaltung zwischen Mono- und Stereowiedergabe sowie die automatische Verstärkungsregelung AGC (automatic gain control) und die automatische Frequenznachstimmung AFC (automatic frequency control), die eine laufende Nachregelung unnötig machen. In neuerer Zeit hinzugekommen ist die Möglichkeit, Begleitdaten von Rundfunksendungen auszuwerten, wobei nicht die technisch optimale Einstellung, sondern das Erkennen im Vordergrund steht, ob auch tatsächlich eine Sendung dargeboten wird, die subjektiv vom Rundfunkhörer gewollt war. Hierzu wird zusätzlich zur akustischen Darbietung der empfangenen Sendung eine Programmkennung (z.B. SDR3, BR1, WDR2) auf einem Display angezeigt.

Der Erfindung liegt die Aufgabe zugrunde, dem Rundfunkhörer weitere technische Unterstützung beim Einstellen einer Sendung zu geben.

Die Aufgabe wird gelöst durch ein Verfahren nach der Lehre des Hauptanspruchs.

Die Lösung beruht darauf, Begleitdaten mehrerer empfangbarer Rundfunksendungen zur Auswahl einer gewünschten Sendung heranzuziehen.

Vorteilhafte Ausgestaltungen der Erfindung sind den Unteransprüchen und den folgenden Ausführungsbeispielen zu entnehmen.

Im folgenden wird die Erfindung anhand von Ausführungsbeispielen unter Zuhilfenahme der beiliegenden Zeichnungen weiter erläutert.
- Fig. 1: zeigt ein grobes Blockschaltbild eines Rundfunkempfängers mit zwei Empfangsteilen unterschiedlicher Art anhand dessen als erstes Ausführungsbeispiel die automatische Umschaltung auf Bestempfang bei kombinierten RDS-DSR-Empfängern erklärt wird. (RDS = Radio-Daten-System, DSR = Digitaler Satelliten Rundfunk)
- Fig. 2: zeigt ein Ablaufdiagramm eines Ausführungsbeispiels zur Wahl der Programmart bei DAB (= Digital Audio Broadcasting).
- Fig. 3: zeigt ein Ablaufdiagramm eines Ausführungsbeispiels zur Blocküberschreitenden Programmartwahl bei Tunern für den DSR.
- Fig. 4: zeigt ein Ablaufdiagramm eines Ausführungsbeispiels zum automatischen Ein- und Ausschalten eines angeschlossenen Aufnahmegerätes.

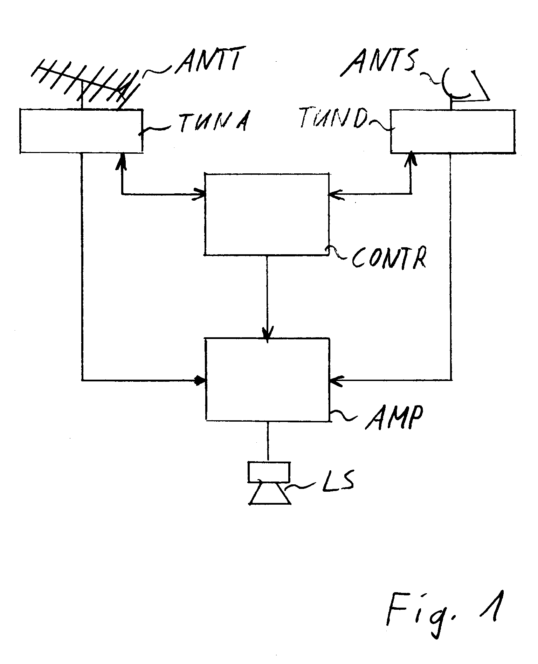

Der Rundfunkempfänger nach Figur 1 weist einen analogen Tuner TUNA, einen digitalen Tuner TUND, ein Steuer- und Bedienteil CONTR, einen Verstärker AMP und eine Lautsprecheranordnung LS auf. Der analoge Tuner TUNA ist an eine terrestrische Antenne ANTT angeschlossen, der digitale Tuner TUNB an eine Satellitenantenne ANTS.

Der analoge Tuner TUNA weist einen UKW-Empfangsteil und eine Dekodierschaltung für RDS-Daten auf. Damit kann aus Sendungen von Sendern, die Begleitdaten nach dem Radio-Daten-System ausstrahlen, unter anderem die Programmkennung ermittelt werden. Eine empfangene Programmkennung wird an das Steuer- und Bedienteil CONTR gemeldet. Vom Steuer- und Bedienteil CONTR erhält der analoge Tuner TUNA Abstimmspannungen oder Abstimmbefehle.

Der digitale Tuner TUND weist einen Satellitenempfangsteil für den Digitalen Satelliten Rundfunk DSR auf. Bei DSR-Empfang wird ebenfalls eine Programmkennung ermittelt. Diese wird, wie beim analogen Tuner, an das Steuer- und Bedienteil CONTR gemeldet. Auch der digitale Tuner TUND erhält vom Steuer- und Bedienteil CONTR Abstimmspannungen oder Abstimmbefehle.

Die demodulierten Empfangssignale sowohl des analogen Tuners TUNA als auch des digitalen Tuners TUND werden dem Verstärker AMP zugeführt. Dieser erhält vom Steuer- und Bedienteil CONTR eine Schaltspannung zur Auswahl eines seiner beiden Eingangssignale. Das ausgewählte Signal wird verstärkt an die Lautsprecheranordnung LS abgegeben.

Das Steuer- und Bedienteil CONTR weist die üblichen Eingabefelder für manuelle Bedienung sowie für Fernbedienung, wie auch die üblichen Anzeigefelder auf. Der Rundfunkhörer kann nun über das Steuer- und Bedienteil CONTR am analogen Tuner TUNA auf einen beliebigen Sender abstimmen oder einen vorabgestimmten Sender aufrufen. Er kann aber auch einen vom digitalen Tuner TUND empfangbaren Sender anwählen. Auch eine Auswahl per Suchlauf ist möglich. Entsprechend der getroffenen Auswahl wird der Verstärker AMP geschaltet.

Nun wird erfindungsgemäß immer dann, wenn am analogen Tuner TUNA ein Sender eingestellt wurde, der eine Programmkennung mit ausstrahlt, geprüft, ob über den digitalen Tuner TUND dasselbe Programm empfangbar ist. Dies kann über einen Suchlauf erfolgen oder duch Vergleich mit Tabellen, die entweder fest einprogrammiert sind oder bei früheren Einstellungen oder Suchläufen ermittelt wurden.

Wird festgestellt, daß das am analogen Tuner TUNA ausgewählte Programm auch über den digitalen Tuner TUND empfangbar ist, so wird automatisch auf diesen umgeschaltet. Dabei wird unterstellt, daß die am digitalen Tuner verwendete Modulationsart PCM prinzipiell eine bessere Übertragung garantiert als die am analogen Tuner verwendete Modulationsart FM. Für Tests und Ausnahmesituationen ist diese Automatik abschaltbar.

Anstelle eines Satellitenempfangsteils für DSR oder auch zusätzlich dazu kann der digitale Tuner auch ein Empfangsteil für DAB (Digital Audio Broadcasting) aufweisen, ohne daß sich sonst etwas ändert.

Anhand des Ablaufdiagramms in Figur 2 wird nun ein weiteres Ausführungsbeispiel des erfindungsgemäßen Verfahrens beschrieben.

Angenommen wird dabei ein Empfänger für DAB (Digital Audio Broadcasting), der automatisch auf verschiedene Sender einstellbar ist. Weiter wird angenommen, daß zumindest ein Teil der empfangbaren Sender eine Programmartkennung als Teil seiner Begleitdaten mit aussendet.

Der in Figur 2 gezeigte Verfahrensablauf wird bei Start gestartet, indem eine gewünschte Programmart, wie Klassik, Sport oder Nachrichten als Einstellhandlung vorgegeben wird. Gleichzeitig wird die Wiedergabe des laufenden Programms unterbrochen. Anschließend erfolgt eine Abfrage Q, ob das gerade eingestellte Programm die Kennung der gewünschten Programmart aufweist. Wenn ja, wird bei Stop die Suche beendet und die Wiedergabe freigegeben. Wenn nein, wird bei Next der nächste empfangbare Sender eingestellt, woraufhin dieselbe Abfrage Q erfolgt. Dabei werden alle empfangbaren Sender zyklisch eingestellt.

Dieser Ablauf kann dahingehend abgewandelt werden, daß zunächst alle empfangbaren Sender abgefragt werden und daß dann auf einer Anzeige dem Rundfunkhörer angezeigt wird, welche der empfangbaren Sender gerade die gewünschte Programmart senden. Der Rundfunkhörer kann dann entweder gezielt einen Sender anwählen oder durch mehrmaligen Start des in Figur 2 gezeigten Ablaufs seine Wahl treffen.

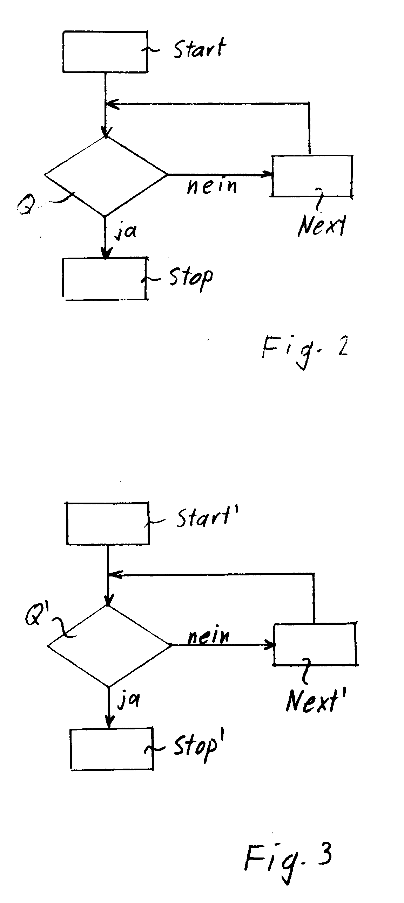

Das Ablaufdiagramm des anhand der Figur 3 beschriebenen weiteren Ausführungsbeispiels sieht äußerlich gleich aus wie das von Figur 2, hat jedoch andere Bedeutungen.

Angenommen wird hier ein Rundfunkempfangsgerät für den Digitalen Satelliten Rundfunk DSR. Bei DSR werden Tonkanäle in digitalisierter Form zusammen mit Begleitdaten zu einem Zeitmultiplexsignal zusammengefaßt als Block übertragen. Ein bestimmter Sender wird also dadurch eingestellt, daß zunächst der Block ausgewählt wird, in dem der Tonkanal (bei Mono) oder das Paar von Tonkanälen (bei Stereo) untergebracht ist und daß dann innerhalb des Blocks der gewünschte Tonkanal bzw. das gewünschte Tonkanalpaar aus dem Zeitmultiplexsignal ausgeblendet wird.

Grundsätzlich wird also immer ein kompletter Block empfangen, aber nur teilweise ausgewertet. Die gleichzeitige Auswertung der Begleitdaten aller Tonkanäle eines Blocks ist aber problemlos möglich. Es ist auch schon bekannt, daß bei Vorgabe einer gewünschten Programmart sofort all diejenigen Programme angezeigt werden, die innerhalb des gerade empfangenen Blocks die gewünschte Programmart senden. Gemäß der Erfindung wird dies nun nach Figur 3 auf alle überhaupt empfangbaren Programme erweitert. Der in Figur 3 gezeigte Verfahrensablauf wird bei Start' gestartet, indem eine gewünschte Programmart vorgegeben wird. Gleichzeitig wird die Weitergabe des laufenden Programms unterbrochen. Anschließend erfolgt eine Abfrage Q', ob eines der im gerade eingestellten Block enthaltenen Programme die Kennung der gewünschten Programmart aufweist. Wenn ja, wird bei Stop' die Suche beendet, der Tonkanal oder das Tonkanalpaar des ersten Senders innerhalb dieses Blocks mit der gewünschten Programmart ausgeblendet und die Wiedergabe freigegeben. Wenn nein, wird bei Next' der nächste empfangbare Block eingestellt, woraufhin dieselbe Abfrage Q' erfolgt. Alle empfangbaren Blöcke werden dabei zyklisch eingestellt.

Auch dieser Ablauf kann dahingehend abgewandelt werden, daß zunächst alle empfangbaren Blöcke eingestellt und alle empfangbaren Sender angezeigt werden, die gerade die gewünschte Programmart senden. Hier ist noch eine weitere Abwandlung des Ablaufs möglich, wonach bei jedem Neustart zunächst innerhalb des gerade eingestellten Blocks zum nächsten Sender mit der gewünschten Programmart geschaltet und dort der Ablauf beendet wird, bevor zum nächsten Block übergegangen wird.

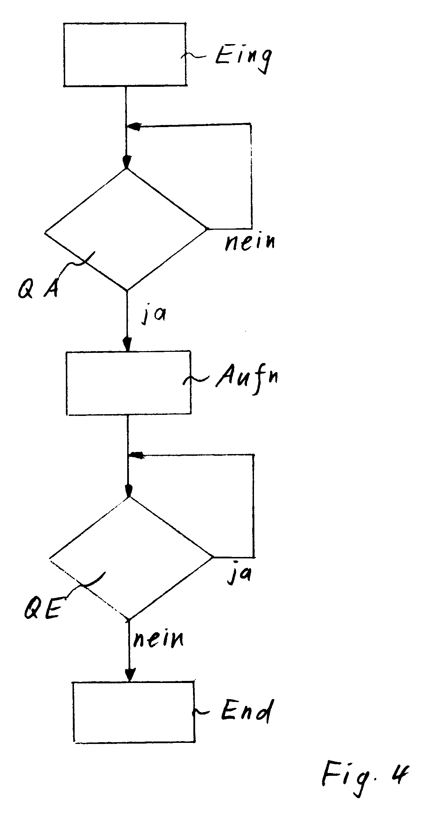

Anhand des Ablaufdiagramms von Figur 4 wird noch ein weiteres Ausführungsbeispiel beschrieben, bei dem die aus Einstellhandlungen gewonnenen Daten und die als Begleitdaten empfangenen Daten verwendet werden, um ein angeschlossenes Tonaufnahmegerät automatisch für die Dauer einer ganz bestimmten Sendung automatisch ein- und auszuschalten. Dies entspricht der bekannten Funktion des Video Program Systems VPS bei Videorekordern und wird deshalb hier als Audio Program System APS bezeichnet.

Der Verfahrensablauf beginnt nach Figur 4 mit einer Eingabephase Eing. Dabei wird das gewünschte Programm und innerhalb des Programmes die gewünschte Sendung vorgegeben. Zur Vorgabe der gewünschten Sendung muß auf Angaben zurückgegriffen werden, die vom Programmanbieter vorher bekannt gemacht werden und die dieser dann in den Begleitdaten sendet, wenn und solange diese Sendung tatsächlich gesendet wird. Wie bei VPS kann dies auch beim vorliegenden APS die ursprünglich vorgesehene Sendezeit sein, die dann aber bei allen Programmänderungen, auch den bekanntgemachten, als Kennung beibehalten werden muß. Aber auch andere Arten von Kennungen sind möglich, beispielsweise durchlaufende Numerierungen oder Kennzeichnungen der Programmart, möglicherweise auch kombiniert zu verwendende Kennungen wie Nachrichten, Sport, Wetterbericht einerseits, regional, überregional, international andererseits.

Nach der Eingabe in der Eingabephase Eing wird zur ersten Abfrage QA übergegangen, wo überprüft wird, ob die vorgegebene Kennung mit der empfangenen Kennung übereinstimmt. Wenn ja, wird zur Aufnahme Aufn weitergegangen, wenn nein, wird die Abfrage QA erneut gestellt. Bei Aufnahme Aufn wird das angeschlossene Tonaufnahmegerät gestartet und zur nächsten Abfrage QE weitergegangen. Solange die Kennungen übereinstimmen, also bei "ja", wird die Abfrage QE wiederholt. Bei "nein" wird zum Ende End weitergegangen, wo das angeschlossene Tonaufnahmegerät wieder abgeschaltet wird. Selbstverständlich kann dieser Ablauf, wie bei VPS bekannt, um weitere Abfragen für weitere aufzunehmende Sendungen erweitert werden.

Das anhand der Figur 4 beschriebene Verfahren bietet sich zur Anwendung auf alle Tonrundfunk-Übertragungsarten an, bei denen Begleitdaten mit übertragen werden, beispielsweise bei den schon genannten Systemen DAB, DSR und RDS. Eine Umschaltung auf reine Zeitsteuerung ist, wie bei VPS-tauglichen Videorekordern, auch hier möglich.

## Patentansprüche

1. Verfahren zur Unterstützung eines Rundfunkhörers beim Einstellen einer Sendung an einem Rundfunkempfangsgerät, **dadurch gekennzeichnet,** daß das Rundfunkempfangsgerät selbständig eine Sendung einstellt aufgrund eines Vergleichs zwischen Daten, die aus Einstellhandlungen des Rundfunkhörer gewonnen wurden und Daten, die vom Rundfunkempfangsgerät als Begleitdaten von Rundfunksendungen empfangen wurden.

2. Verfahren nach Anspruch 1, dadurch gekennzeichnet, daß das Rundfunkempfangsgerät dann, wenn es aufgrund von zusammen mit Rundfunksendungen empfangenen Daten erkennt, daß ein und diesselbe vom Rundfunkhörer zum Empfang ausgewählte Rundfunksendung sowohl in einer ersten Modulationsart (FM) moduliert als auch in einer zweiten Modulationsart (PCM) moduliert empfangbar ist, automatisch die Einstellung so vornimmt, daß die Übertragung mit der prinzipiell höherwertigen Modulationsart (PCM) ausgenützt wird.

3. Verfahren nach Anspruch 1, dadurch gekennzeichnet, daß die empfangbaren Rundfunksendungen daraufhin verglichen werden, ob sie gerade einer vom Rundfunkhörer vorgegebenen Programmart angehören und daß alle Rundfunksendungen mit dieser Programmart in einer Tabelle gespeichert werden.

4. Verfahren nach Anspruch 3, dadurch gekennzeichnet, daß die in der Tabelle gespeicherten Rundfunksendungen auf einem Display angezeigt werden.

5. Verfahren nach Anspruch 3, dadurch gekennzeichnet, daß die in der Tabelle gespeicherten Rundfunksendungen nach Art eines Suchlaufs der Reihe nach eingestellt und dargeboten werden.

6. Verfahren nach Anspruch 3, dadurch gekennzeichnet, daß das Rundfunkempfangsgerät dann, wenn es Sendungen zu empfangen vermag, die aufgrund ihrer technischen Übertragungsart verschiedenen Gruppen angehören, alle Gruppen daraufhin überprüft, welche der gerade empfangbaren Rundfunksendungen der vorgegebenen Programmart angehören und daß aus allen Gruppen alle Rundfunksendungen mit dieser Programmart in der Tabelle gespeichert werden.

7. Verfahren nach Anspruch 1, dadurch gekennzeichnet, daß einzelne zu empfangende Sendungen vorgegeben werden können und daß ein Schaltsignal abgegeben wird, wenn die aus dieser Vorgabe gewonnenen Daten mit empfangenen Daten übereinstimmen.
